# EUROPÄISCHE PATENTSCHRIFT

(11) **EP 0 848 583 B1**
(45) Veröffentlichungstag und Bekanntmachung des Hinweises auf die Patenterteilung: **26.03.2003**
(21) Anmeldenummer: 97117125.1
(22) Anmeldetag: 02.10.1997
(51) Int. Cl.: H05K 1/00

(54) **Anzeigevorrichtung**
Display device
Dispositif d'affichage

(30) Priorität: 13.12.1996 DE 19651863
(43) Veröffentlichungstag der Anmeldung: 17.06.1998
(73) Patentinhaber: ROBERT BOSCH GMBH, 70442 Stuttgart (DE)
(72) Erfinder: Bentz, Willy, 74343 Sachsenheim (DE); Wiesa, Thomas, 71665 Vaihingen (DE); Karr, Dieter, 75233 Tiefenbronn (DE); Ernst, Waldemar, 71665 Vaihingen (DE)

(56) Entgegenhaltungen:
- EP-A- 0 126 856
- DE-A- 3 500 899
- DE-A- 3 904 656
- US-A- 4 569 885

## Beschreibung

### Stand der Technik

Die Erfindung betrifft eine Anzeigevorrichtung, insbesondere für ein Kraftfahrzeug, mit mindestens einem auf einem Substrat angeordneten Bauelement.

Kombinationsinstrumente, insbesondere für Kraftfahrzeuge, zur Anzeige von beispielsweise Meßwerten sind bekannt. Diese weisen neben Gehäuse, Deckscheibe, Zeigern, Beleuchtungskörpern und elektrotechnischen Bauteilen häufig Substrate auf, die als Schaltungsträger und auch zur Herstellung elektrischer Verbindungen von Zeigerantrieben und Beleuchtungskörpern dienen.

Bei diesen Anzeigevorrichtungen hängt die geometrische Form des Substrats und dessen Größe von der Anordnung der Zeigerinstrumente und Beleuchtungskörper ab, ist mithin also designabhängig. Das heißt, die geometrischen Abmessungen des im Stand der Technik verwendeten Substrats müssen individuell an die verschieden ausgeführten Kombinationsinstrumente angepaßt werden.

Aus der DE 35 00 899 A1 ist ein Anzeigeinstrument mit quasikontinuierlicher, einem Zeigerinstrument ähnlicher Darstellung bekannt, bei dem Leuchtdioden mittels Lötverbindungen von einer Leiterplatte gehalten werden. Die Leiterplatte nimmt in den Leuchtdioden auch die für die Signalaufbereitung notwendigen Schaltkreise auf. Aus der EP 126 856 A2 ist ein Verfahren zur Herstellung von Leiterplatten mit starren und flexiblen Bereichen bekannt, bei dem die Basisplatte mit einer flexiblen, Kupferkaschierten Folie überklebt ist. Nach der Bestückung der Leiterplatte wird durch Bruchtrennen die Leiterplatte in starre und flexible Bereiche unterteilt.

Nachteilig ist im Stand der Technik, daß durch die designabhängige Anordnung der Zeigerinstrumente und Beleuchtungskörper häufig nur eine sehr ungünstige Flächenausnutzung des Substrats erzielt werden kann.

Nachteilig ist im Stand der Technik weiterhin, daß für jedes Kombinationsinstrument und für jede Anordnungsvariante der Instrumente und Beleuchtungskörper eine individuelle Größe und Form des zur Instrumentenherstellung eingesetzten Substrats notwendig ist.

### Vorteile der Erfindung

Die Erfindung betrifft eine Anzeigevorrichtung, insbesondere für ein Kraftfahrzeug, mit mindestens einem auf einem Montagesubstrat angeordneten Bauelement, wobei das Montagesubstrat durch Öffnen der Perforation eines mindestens eine Perforation aufweisenden Ausgangssubstats herstellbar ist.

Die Erfindung mit den Merkmalen des Anspruchs 1 hat den Vorteil, daß sich mittels mindestens einer Perforation des Ausgangssubstrats einfach und kostengünstig Montagesubstrate unterschiedlicher Geometrie verwirklichen lassen, wobei die geometrischen Abmessungen des Ausgangssubstrats im wesentlichen designunabhängig, also unabhängig vom Modell der Anzeigevorrichtung und der Anordnung der Zeigerinstrumente und der Beleuchtungskörper zueinander sind. Das Ausgangssubstrat, beispielsweise eine Polyester-Folie, kann designunabhängig und weitgehend standardisiert hergestellt und ausgeführt werden, wobei dennoch unterschiedliche Anordnungen der Zeigerinstrumente und Beleuchtungskörper sowie verschiedenste Ausführungsmodelle der Kombinationsinstrumente verwirklicht werden können. Durch den Einsatz eines durch öffnen, beispielsweise Stanzen oder Reißen, aus dem Ausgangssubstrat hergestellten Montagesubstrats als Bauelementträger und elektrisches Verbindungselement für elektrische und elektromechanische Komponenten ergibt sich ein weiterer Vorteil dadurch, daß sich eine sehr günstige Flächenausnützung des Substrats erzielen läßt. Die Herstellungskosten lassen sich so drastisch reduzieren. Ein weiterer Vorteil der ein perforiertes Ausgangssubstrat verwendenden erfindungsgemäßen Anzeigevorrichtung besteht darin, daß nach dem Öffnen der Perforationen ein so entstandener Substratstreifen umgeklappt werden kann, so daß sich bei einer einseitigen Bestückung des Substrats mit Bauelementen verschiedener Art vorteilhafterweise auch auf der Substratrückseite Bauelemente oder dergleichen anbringen lassen.

Im Zusammenhang mit der vorliegenden Erfindung wird unter dem Ausgangssubstrat das mindestens eine Perforation aufweisende Substrat im Anlieferungszustand, das heißt nach der Herstellung des Substrates und vor dem Einbau in die Anzeigevorrichtung, verstanden. Im Zusammenhang mit der vorliegenden Erfindung wird unter dem Montagesubstrat das Substrat verstanden, das durch Öffnen, beispielsweise Stanzen oder Reißen, der mindestens einen Perforation des Ausgangssubstrat aus diesem hervorgegangen ist. Nach dem Öffnen der Perforation können Teile des Substrates verschoben, verdreht, umgebogen oder abgeklappt werden, so daß sich der äußere Umriß des Ausgangssubstrats erheblich ändern kann. Die mittels des so hergestellten Montagesubstrats erreichbare Ausdehnung beziehungsweise dessen Verbindungspotential vergrößert sich demgemäß erheblich, so daß auch weiter auseinanderliegende Bauelemente der erfindungsgemäßen Anzeigevorrichtung verbunden werden können.

In einer besonders bevorzugten Ausführungsform betrifft die Erfindung eine vorgenannte Anzeigevorrichtung, wobei das Ausgangssubstrat im wesentlichen eine rechteckige Grundform mit mindestens einer Perforation aufweist. In besonders bevorzugter Weise weist das Ausgangssubstrat zwei zueinander beabstandete und parallel zueinander verlaufende Perforationsstreifen auf, die beispielsweise parallel zu den Längsseiten des Ausgangssubstrats angeordnet sein können. In einer weiteren bevorzugten Ausführungsform ist ein weiterer Perforationsstreifen vorgesehen, der senkrecht von einer Längsseite des Ausgangssubstrats bis zu einem der parallel zu den Längsseiten des Ausgangssubstrats angeordneten anderen Perforationsstreifen verläuft. Durch Öffnen der längs und quer zu den Längsseiten des Ausgangssubstrats verlaufenden Perforationsstreifen lassen sich nach Umklappen oder Verschieben der nach der Öffnung der Perforation entstehenden Substratstreifen unterschiedlich geformte Montagesubstrate herstellen, die vorzüglich als Schaltungsträger und Verbindungselement für elektromechanische Komponenten geeignet sind.

Vorteilhafte Ausgestaltungen der Erfindung ergeben sich aus den abhängigen Ansprüchen.

### Zeichnung

Die Erfindung wird im folgenden anhand eines Ausführungsbeispiels mit Bezug auf die Zeichnungen näher erläutert. Es zeigen:
- Figur 1: eine Explosionszeichnung einer als Kombinationsinstrument ausgeführten Anzeigevorrichtung, wobei das Kombinationsinstrument in einer Seitenansicht mit einem Teilschnitt dargestellt ist,
- Figur 2: eine Draufsicht eines Ausgangssubstrats, das heißt eines Substrats im Anlieferungszustand, mit den erfindungsgemäß vorgesehenen Perforationen und
- Figur 3: eine Draufsicht auf ein Montagesubstrat, das heißt eines sich im Einbauzustand befindenden Substrats, welches verschobene und geklappte Substratstreifen aufweist.

### Ausführungsbeispiel

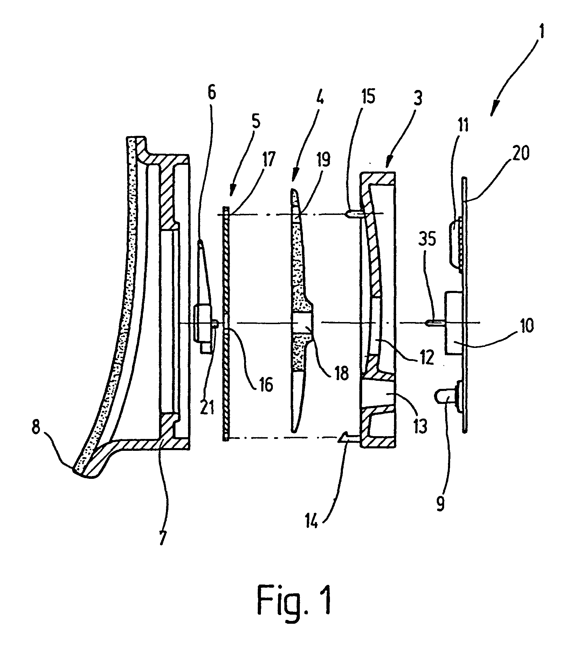

In Figur 1 ist ein Kombinationsinstrument 1 in einer Explosionszeichnung dargestellt. Das Kombinationsinstrument 1 umfaßt ein Montagesubstrat 20, beispielsweise eine Polyester-Folie, einen Reflektor 3, eine Leuchtscheibe 4, ein Zifferblatt 5, einen Zeiger 6, einen Frontrahmen 7 sowie eine Deckscheibe 8. Auf dem Montagesubstrat 20 ist ein Leuchtmittel 9, ein Zeigerantrieb 10 und ein elektronisches Bauteil 11 angebracht. Der Reflektor 3 weist ein Mittelloch 12 sowie einen Durchbruch 13, ein Befestigungselement 14 sowie eine Fixierungseinrichtung 15 auf.

Die Leuchtscheibe 4 weist ebenfalls ein Mittelloch 18 sowie eine Aufnahmeeinrichtung 19, die zur Aufnahme der Fixierungseinrichtung 15 dient, auf.

Dem Zifferblatt 5 ist ein Mittelloch 16 sowie eine Aufnahme 17 für die Fixierungseinrichtung 15 zugeordnet.

Dargestellt ist ferner ein hinter dem Frontrahmen 7 und der Deckscheibe 8 angeordneter und mit dem Zeigerantrieb 10 verbundener Zeiger 6. Daraus ergibt sich für das zusammengesetzte Kombinationsinstrument 1, das hier nicht dargestellt ist, ein Aufbau, bei dem die Leuchtscheibe 4 in den Reflektor 3 eingesetzt wird, so daß die Fixierungseinrichtung 15 in die Aufnahmeeinrichtung 19 eingreift und die Leuchtscheibe 4 vom Befestigungselement 14 gehalten wird, wobei die Mittelachsen der Leuchtscheibe 4 und des Reflektors 3 miteinander fluchten. Nachdem die Leuchtscheibe 4 in den Reflektor 3 eingesetzt wurde, wird das Zifferblatt 5 in gleicher Weise wie die Leuchtscheibe 4 dem Reflektor 3 zugeordnet. Das erfolgt dadurch, daß das Zifferblatt 5 auf den Reflektor 3 aufgesteckt wird, wobei die Fixierungseinrichtung 15 in die Aufnahmeeinrichtung 17 eingreift und das Zifferblatt 5 durch das Befestigungselement 14 gehalten wird, wobei die Mittelachsen der so zusammengesetzten Teile miteinander fluchten. Anschließend wird das Montagesubstrat 20 von der in Figur 1 dargestellten rechten Seite auf den Reflektor 3 aufgesteckt. Das Montagesubstrat 20 kann hierbei durch hier nicht dargestellte Befestigungsmittel auf dem Reflektor 3 befestigt werden. Ist das Montagesubstrat 20 dem Reflektor 3 zugeordnet, so erstreckt sich das Leuchtmittel 9 in den Durchbruch 13 und der Zeigerantrieb 10 ragt mit einer Antriebsachse 35 durch die Mittellöcher 12, 18 und 16. Nachdem der Zusammenbau des Kombinationsinstruments 1 soweit bewerkstelligt ist, kann der Zeiger 6 mit einem Fortsatz 21, der eine hier nicht sichtbare Aufnahme beinhaltet, auf die Antriebsachse 35 des Zeigerantriebs 10 aufgesteckt werden. Nachdem der Zeiger 6 auf der Antriebsachse 35 befestigt wurde, kann die so entstandene Einheit, bestehend aus Montagesubstrat 20, Reflektor 3, Leuchtscheibe 4 und Zifferblatt 5 mit dem Frontrahmen 7 verbunden werden. Auf dem Frontrahmen 7 ist zum Schutz des Anzeigeinstruments, das heißt, zum Schutz der beweglichen Elemente, beispielsweise des Zeigers 6, eine Deckscheibe 8 aufgebracht.

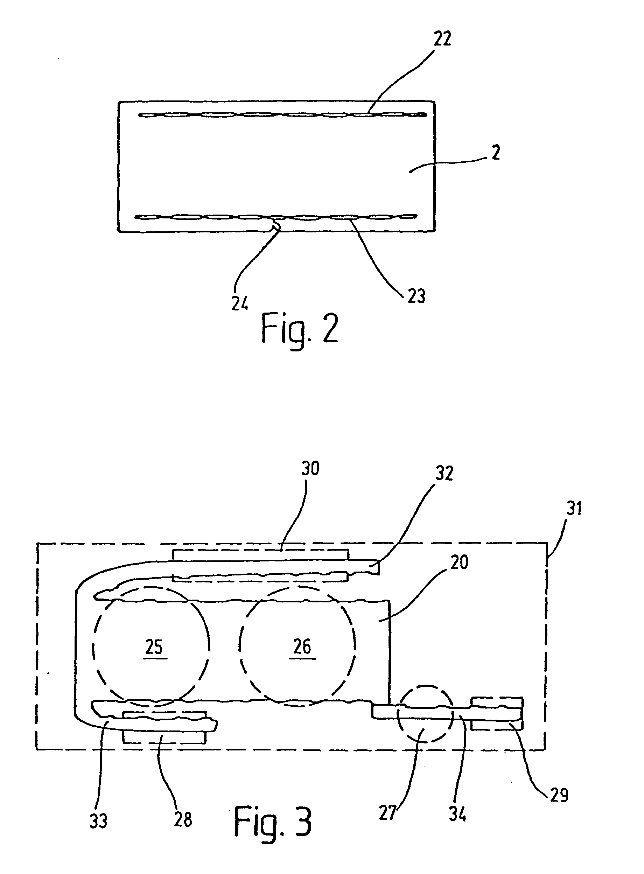

Figur 2 zeigt das Ausgangssubstrat 2 mit einem ersten Perforationsstreifen 22 und einem zweiten Perforationsstreifen 23, dem ein weiterer Perforationsstreifen 24 rechtwinklig zugeordnet ist. Die Perforationsstreifen 22 und 23 sind parallel und beabstandet zueinander entlang der Längsseiten des Ausgangssubstrats 2 angeordnet.

Wie bereits erwähnt, ist das hier dargestellte Ausgangssubstrat 2 ein Substrat im "Anlieferungszustand". Das heißt, die Perforationsstreifen 22, 23 und 24 sind noch nicht geöffnet.

Figur 3 zeigt das Montagesubstrat 20, nachdem es sämtliche notwendigen Bearbeitungs- und Bestükkungsvorgänge durchlaufen hat, wobei hier Leiterbahnen und Bauelemente nicht dargestellt sind. Insbesondere unterscheidet sich das Montagesubstrat 20 vom Ausgangssubstrat 2 durch das erfolgte Öffnen der Perforationsstreifen 22, 23 und 24 und die räumliche Neuordnung der entstandenen Substratstreifen 32, 33 und 34. Das Montagesubstrat 20 befindet sich demgemäß im "Einbauzustand".

Beispielhaft sind hier Anzeigeinstrumente 25, 26 und 27 gestrichelt dargestellt. Weiterhin sind Zustandsanzeiger verschiedener Fahrzeugfunktionen gezeigt, beispielsweise Warnleuchten 28, 29 sowie eine Kontrollampe 30 für einen Fahrtrichtungsanzeiger. Die hier beispielhaft angeordneten Anzeigeinstrumente 25, 26 und 27, die Warnleuchten 28, 29 und die Kontrolleuchte 30 sind Bestandteil einer hier nur schematisch dargestellten Instrumententafel 31 eines hier nicht dargestellten Kraftfahrzeugs.

Wie in Figur 3 erkennbar, werden nach dem öffnen der Perforationsstreifen 22, 23 und 24 entsprechende Substratstreifen 32, 33 und 34 freigegeben. Die so entstandenen Substratstreifen 32, 33 und 34 können sowohl in einer Ebene relativ zum Hauptteil des Montagesubstrat 20 verschoben werden, wie dies durch die Substratstreifen 32 und 33 angezeigt wird, als auch umgeklappt werden, wie im Fall des Substratstreifens 34 dargestellt.

Mit den so hergestellten und räumlich angeordneten Substratstreifen 32, 33 und 34 läßt sich in materialsparender Weise leicht eine elektrische Verbindung zwischen den Anzeigeinstrumenten 25, 26 und 27, den Warnleuchten 28, 29 und der Kontrolleuchte 30 herstellen.

Es ist leicht ableitbar, daß mit derselben geometrischen Form des Ausgangsubstrats 2, jedoch mit anders verlaufenden oder weiteren Perforationsstreifen eine andere Anordnung der Anzeigeinstrumente, der Warnleuchten und Kontrolleuchten verwirklicht werden kann, wobei auch elektronische Bauteile und Leuchtmittel den jeweiligen Anzeigeelementen individuell zugeordnet werden können.

Nach alledem wird klar, daß der Einsatz eines perforierten Ausgangssubstrats als Bauelementträger und elektrisches Verbindungselement für elektromechanische und elektrotechnische Komponenten einer Anzeigevorrichtung in vorteilhafter Weise möglich ist. Weiterhin ermöglicht das perforierte Ausgangssubstrat eine materialreduzierte und damit kostengünstige Herstellung der Anzeigevorrichtung und eine optimale Ausnutzung der vorhandenen Substratfläche.

Weiterhin ist ersichtlich, daß Substratstreifen, die nach Öffnen der Perforierung gebildet werden, sowohl in der Ebene verschoben als auch geklappt werden können. Geklappte Substratstreifen weisen den Vorteil auf, daß bei einer einseitigen Bestükkung des Substrats in einem Arbeitsgang Beleuchtungsmittel oder ähnliches auf der Substratrückseite aufgebracht werden können. Dies reduziert die Bearbeitungskosten.

Es ist jedoch auch denkbar, daß, nachdem der Substratstreifen umgeklappt und seine Rückseite bestückt wurde, der Substratstreifen wieder zurückgeklappt wird, um anschließend seine Vorderseite zu bestücken.

## Patentansprüche

1. Anzeigevorrichtung, insbesondere für ein Kraftfahrzeug, mit mindestens einem auf einem Montagesubstrat angeordneten Bauelement, wobei das mindestens eine Bauelement ein Zeigerantrieb, ein Leuchtmittel oder ein elektrotechnisches Bauteil ist,
**dadurch gekennzeichnet, dass** das Montagesubstrat (20) durch Öffnen der Perforation (22, 23, 24) eines mindestens eine Perforation aufweisenden Ausgangssubstrats (2) herstellbar ist, dass nach dem Öffnen der Perforation (22, 23, 24) Substratstreifen (32, 33, 34) gebildet sind, dass die Substratstreifen ( 32, 33) in einer Ebene verschiebbar sind und dass durch die Verschiebung der Substratstreifen (32, 33) die Ausdehnung des Montagesubstrates (20) gegenüber dem Ausgangssubstrat (2) vergrößerbar ist.

2. Anzeigevorrichtung nach Anspruch 1, **dadurch gekennzeichnet, dass** die Substratstreifen (34) umklappbar sind.

3. Anzeigevorrichtung nach Anspruch 2, **dadurch gekennzeichnet, dass** das Ausgangssubstrat (2) im wesentlichen eine rechteckige Grundform aufweist.

4. Anzeigevorrichtung nach einem der vorhergehenden Ansprüche, **dadurch gekennzeichnet, dass** das Ausgangssubstrat (2) zwei Perforationsstreifen (22, 23), die vorzugsweise parallel und beabstandet zueinander angeordnet sind, aufweist.

5. Anzeigevorrichtung nach einem der vorhergehenden Ansprüche, **dadurch gekennzeichnet, dass** das Ausgangssubstrat (2) einen weiteren Perforationsstreifen (24) aufweist, der vorzugsweise zu den parallelen Perforationsstreifen (22, 23) rechtwinklig verläuft.

6. Anzeigevorrichtung nach einem der vorhergehenden Ansprüche, **dadurch gekennzeichnet, dass** das Ausgangssubstrat (2) eine Folie, insbesondere eine Polyester-Folie ist.

7. Anzeigevorrichtung nach einem der vorhergehenden Ansprüche, **dadurch gekennzeichnet, dass** das elektrotechnische Bauteil (11) ein integrierter Schaltkreis ist.

8. Anzeigevorrichtung nach einem der vorhergehenden Ansprüche, **dadurch gekennzeichnet, dass** das Montagesubstrat (20) hinter einem Reflektor (3) angebracht ist und dass auf der dem Montagesubstrat (20) abgewandten Seite des Reflektors (3) hintereinander eine Leuchtscheibe (4), ein Ziffernblatt (5), ein Zeiger (6), ein Frontrahmen (7) und eine Deckscheibe (8) angebracht sind.

9. Verfahren zur Herstellung einer Anzeigeeinrichtung, insbesondere für ein Kraftfahrzeug, mit einem Montagesubstrat als Bauelementträger und elektrisches Verbindungselement für elektrische und elektromechanische Verbindungen, **dadurch gekennzeichnet, dass** das Herstellverfahren zumindest die folgenden Schritte beinhaltet:
- Herstellung eines Ausgangssubstrates (2) mit mindestens einer Perforation (22, 23, 24),
- Herstellung des Montagesubstrates (20) durch Öffnen der Perforation (22, 23, 24),
- Verschieben von nach dem Öffnen entstehender Substratstreifen (32, 33) und Vergrößerung der Ausdehnung des Montagesubstrates (20) gegenüber dem Ausgangssubstrat (2) durch das Verschieben und
- Herstellung einer elektrischen Verbindung zwischen den Anzeigeinstrumenten (25, 26, 27), den Warnleuchten (28, 29) und den Kontrollleuchten (30) mit den Substratstreifen (32, 33, 34).

10. Verfahren nach Anspruch 9, **dadurch gekennzeichnet, dass** die Substratstreifen (34) umgeklappt werden.

## Claims

1. Display device, in particular for a motor vehicle, having at least one structural element arranged on an installation substrate, the at least one structural element being a pointer drive, an illuminating means or an electrotechnical component, **characterized in that** the installation substrate (20) can be produced by opening the perforation (22, 23, 24) in a starting substrate (2) having at least one perforation, **in that** after opening the perforation (22, 23, 24) substrate strips (32, 33, 34) are formed, **in that** the substrate strips (32, 33,) can be displaced in a plane, and **in that** by means of the displacement of the substrate strips (32, 33) the extent of the installation substrate (20) can be enlarged in comparison with the starting substrate (2).

2. Display device according to Claim 1, **characterized in that** the substrate strips (34) can be folded over.

3. Display device according to Claim 2, **characterized in that** the starting substrate (2) essentially has a rectangular basic shape.

4. Display device according to one of the preceding claims, **characterized in that** the starting substrate (2) has two perforation strips (22, 23) which are arranged preferably parallel and spaced apart from each other.

5. Display device according to one of the preceding claims, **characterized in that** the starting substrate (2) has a further perforation strip (24) which preferably runs at right angles to the parallel perforation strips (22, 23).

6. Display device according to one of the preceding claims, **characterized in that** the starting substrate (2) is a film, in particular a polyester film.

7. Display device according to one of the preceding claims, **characterized in that** the electrotechnical component (11) is an integrated switching circuit.

8. Display device according to one of the preceding claims, **characterized in that** the installation substrate (20) is fitted behind a reflector (3), and **in that** a luminous disc (4), a dial (5), a pointer (6), a front frame (7) and a covering disc (8) are fitted one behind another on that side of the reflector (3) which faces away from the installation substrate (20).

9. Method for producing a display device, in particular for a motor vehicle, having an installation substrate as structural element carrier, and an electrical connecting element for electrical and electromechanical connections, **characterized in that** the production method includes at least the following steps:
- production of a starting substrate (2) having at least one perforation (22, 23, 24),
- production of the installation substrate (20) by opening the perforation (22, 23, 24),
- displacement of substrate strips (32, 33) which arise after opening, and enlargement of the extent of the installation substrate (20) in comparison with the starting substrate (2) by the displacement, and
- production of an electrical connection between the display instruments (25, 26, 27), the warning lights (28, 29) and the control lights (30), and the substrate strips (32, 33, 34).

10. Method according to Claim 9, **characterized in that** the substrate strips (34) are folded over.

## Revendications

1. Dispositif d'affichage, en particulier pour un véhicule automobile, avec au moins un élément de construction placé sur un substrat de montage, où l'élément de construction au moins au nombre d'un est un entraînement d'aiguille, un moyen d'éclairage ou un composant électrotechnique,
**caractérisé en ce que**
le substrat de montage (20) peut être fabriqué en ouvrant la perforation (22, 23, 24) d'un substrat de départ (2) présentant au moins une perforation, qu'après l'ouverture de la perforation (22, 23, 24) sont formées des bandes de substrat (32, 33, 34), que les bandes de substrat (32, 33) peuvent être déplacées dans un plan et que par le déplacement des bandes de substrat (32, 33) l'extension du substrat de montage (20) peut être agrandie par rapport au substrat de départ (2).

2. Dispositif d'affichage selon la revendication 1,
**caractérisé en ce que**
les bandes du substrat (34) peuvent être rabattues.

3. Dispositif d'affichage selon la revendication 2,
**caractérisé en ce que**
le substrat de départ (2) présente pour l'essentiel une forme de base rectangulaire.

4. Dispositif d'affichage selon l'une des revendications précédentes,
**caractérisé en ce que**
le substrat de départ (2) présente deux bandes de perforations (22, 23) qui sont de préférence parallèles et placées à distance l'une de l'autre.

5. Dispositif d'affichage selon l'une des revendications précédentes,
**caractérisé en ce que**
le substrat de départ (2) présente une autre bande de perforation (24) qui s'étend de préférence en angle droit par rapport aux bandes de perforations (22, 23) parallèles.

6. Dispositif d'affichage selon l'une des revendications précédentes,
**caractérisé en ce que**
le substrat de départ (2) est une feuille, en particulier une feuille en polyester.

7. Dispositif d'affichage selon l'une des revendications précédentes,
**caractérisé en ce que**
le composant électrotechnique (11) est un circuit de commutation Intégré.

8. Dispositif d'affichage selon l'une des revendications précédentes,
**caractérisé en ce que**
le substrat de montage (20) est appliqué derrière un réflecteur (3) et que sur le côté du réflecteur (3) opposé au substrat de montage (20) sont appliqués l'un derrière l'autre un disque lumineux (4), un cadran (5), une aiguille (6), un cadre avant (7) et une plaque de recouvrement (8).

9. Procédé pour fabriquer un dispositif d'affichage, en particulier pour un véhicule automobile, avec un substrat de montage en tant que support d'élément de construction et qu'élément de liaison électrique pour des liaisons électriques et électromécaniques,
**caractérisé en ce que**
le procédé de fabrication comprend au moins les étapes de
- fabrication d'un substrat de départ (2) avec au moins une perforation (22, 23, 24),
- fabrication d'un substrat de montage (20) en ouvrant la perforation (22, 23, 24),
- déplacement des bandes de substrat (32,33) obtenues après l'ouverture et agrandissement de l'extension du substrat de montage (20) par rapport au substrat de départ (2) par le déplacement et
- production d'une liaison électrique entre les instruments d'affichage (25, 26, 27), les lumières d'avertissement (28, 29) et les lampes de contrôle (30) avec les bandes de substrat (32, 33, 34).

10. Procédé selon la revendication 9,
**caractérisé en ce que**
les bandes de substrat (34) sont rabattues.
